# EUROPEAN PATENT SPECIFICATION

(11) **EP 1 249 521 B1**
(45) Date of publication and mention of the grant of the patent: **11.01.2006**
(21) Application number: 00956968.2
(22) Date of filing: 06.09.2000
(51) Int. Cl.: C30B 29/36, H01L 21/205, C30B 23/00, C30B 23/02, C30B 25/00, C30B 25/02, C30B 25/20

(54) **SiC SINGLE CRYSTAL AND METHOD FOR GROWING THE SAME**
SIC-EINKRISTALL UND HERSTELLUNGSVERFAHREN DAFÜR
MONOCRISTAL EN SIC ET SON PROCEDE DE CROISSANCE

(30) Priority: 22.12.1999 JP 36459399
(43) Date of publication of application: 16.10.2002
(73) Proprietor: Sixon Inc., Kyoto-shi, Kyoto 606-0841 (JP); Kansai Electric Power C.C., Inc., Osaka-shi, Osaka (JP); MITSUBISHI CORPORATION, Tokyo 100-8086 (JP); Sumitomo Electric Industries, Ltd., Osaka-shi, Osaka 541-0041 (JP)
(72) Inventor: SHIOMI, Hiromu, Suita-shi, Osaka 564-0004 (JP); KIMOTO, Tsunenobu, Fushimi-ku, Kyoto-shi, Kyoto 612-8031 (JP); MATSUNAMI, Hiroyuki, Yawata-shi, Kyoto 614-0000 (JP)
(74) Representative: HOFFMANN EITLE
(86) International application number: PCT/JP2000/006057
(87) International publication number: WO 2001/046500

(56) References cited:
- EP-A- 1 233 085
- EP-A- 1 243 674
- JP-A- 10 017 399
- US-A- 5 958 132
- J. YANG ET AL.: 'Sublimation growth of 6H-SiC crystals on different faces of a 6H-SiC seed' INST. PHYS. CONF. SER. vol. 137, 1994, pages 17 - 20, CHAPTER 1, XP002934216
- Z.Y. CHEN ET AL.: 'Specular surface morphology of 4H-SiC epilayers grown on (1120) face' JPN. J. APPL. PHYS. vol. 38, no. 12A, PART 2, 01 December 1999, pages L1375 - L1378, XP002934217

## Description

### TECHNICAL FIELD

The present invention relates to a SiC single crystal suitable for semiconductor electronic components and a growth method thereof.

### BACKGROUND ART

Current research on a compound semiconductor comprised of such light elements as silicon carbide (SiC) or gallium nitride (GaN) is active. Such a compound semiconductor, which is comprised of light elements, has a feature where the bonding energy is strong, and as a result, the band gap of energy, the dielectric breakdown electric field and thermal conductivity are high. SiC in particular is attracting attention as a material for high efficiency high withstand voltage power devices, high frequency power devices, high temperature operation devices or blue to purple light emitting devices, because of this wide band gap feature. However, because of its strong bonding energy, an SiC compound does not melt in atmospheric temperature, and has difficulty in growing bulk crystals by recrystallizing the melt which is performed with other semiconductors, including silicon (Si).

A known method of growing a bulk SiC single crystal is the so called improved Raleigh method described in Japanese Patent Publication No. S59-48792 and Japanese Patent Laid-Open No. H2-30699. In this improved Raleigh method, a seed crystal comprised of SiC single crystals is set in a crucible made of graphite, material SiC powder is sublimated in a lower pressure atmosphere, and a target scale SiC single crystal is recrystallized on the seed crystal.

In a so called sublimation method, including this improved Raleigh method, mainly an SiC single crystal substrate where the {0001} plane is exposed is used as the seed crystal. However, if an SiC single crystal is grown using an SiC single crystal substrate where the plane orientation is {0001}, a defect called a micro-pipe, which extends in the <0001> axis direction, reaches the surface of the single crystal, so in some cases a leak current is generated when a device is fabricated using the SiC single crystal.

A known technology to solve the problem related to a micro-pipe is a method of growing an SiC single crystal described in Japanese Patent Publication No. 2804860, for example. In this method, an SiC single crystal, in which the crystal plane which is shifted through an angle α in a 60° - 120° range from the {0001} plane, is used as a seed crystal, and preferably an SiC single crystal, in which a {1-100} plane or {11-20} plane is exposed, is used. If such a seed crystal is used, the micro-pipes reaching the surface of the single crystal can be decreased. Other methods of growing SiC single crystal are disclosed in the following european patent applications of the same applicants EP 1243674 and EP 1233085 both published on 15.03.2001 and both claiming the priority date of 06.09.1999.

### DISCLOSURE OF THE INVENTION

The method of growing an SiC single crystal described in Patent Publication No. 2804860 has the following problem. As the inventors of the invention described in Physical Status Solids (b) (No. 202, pp. 163-175, 1997), when an SiC single crystal where the {1-100} plane or {11-20} plane is exposed is used as a seed crystal, crystal polymorphy can be suppressed, and a micro-pipe reaching the surface can be suppressed, but a high density stacking fault is exposed on the surface of the SiC single crystal. This stacking fault spreads on the plane, and if a device is fabricated using such an SiC single crystal where a stacking fault is exposed on the surface, a leak current may be generated, just like the case of using an SiC single crystal where a micro-pipe exposed on the surface is used.

With the foregoing in view, it is an object of the present invention to provide an SiC single crystal where micro-pipes and stacking faults exposed on the surface are decreased, and a growth method thereof.

The present invention is a method of growing an SiC single crystal, characterized in that an SiC single crystal is grown on a seed crystal comprised of an SiC single crystal in which a plane shifted with respect to a {0001} plane through an angle α (20° < α 60°), where an angle β, formed between a vector, when the normal vector thereof is projected on the {0001} plane, and the <11-20> orientation, is within 15°, is exposed, provided that β=0° is excluded.

According to the method of growing an SiC single crystal of the present invention where a seed crystal in which such a plane is exposed is'used, a micro-pipe which extends in the <0001> orientation and a stacking fault which spreads on a plane perpendicular to the <0001> orientation reaches the side face of the SiC single crystal, and the reach of the micro-pipe and stacking fault to the surface can be suppressed.

Angle α is preferably 25° or more and 55° or less, and angle β is preferably within 10°.

In the method of growing the SiC single crystal of the present invention, it is preferable that the seed crystal is placed in a crucible made of graphite, and the SiC single crystal is recrystallized on the seed crystal by sublimating the SiC material powder in the crucible. The seed crystal may be placed in a reactor, so that the SiC single crystal is grown on the seed crystal in the reactor by a chemical vapor deposition method.

### BRIEF DESCRIPTION OF THE DRAWINGS

Fig. 1 is a cross-sectional view depicting a crystal growth system for growing an SiC single crystal of the present invention;
Fig. 2 is a diagram depicting the exposed plane of the seed crystal used for the present invention;
Fig. 3 is a diagram depicting the status of micro-pipes and stacking faults in the SiC single crystal; and
Fig. 4 is a diagram depicting the angle β.

### BEST MODE FOR CARRYING OUT THE INVENTION

Preferred embodiments of an SiC single crystal and the growth method thereof according to the present invention will now be described with reference to the accompanying drawings. In the descriptions on the embodiments and examples, a lattice orientation and lattice plane of the crystals are used. Now the symbols of the lattice orientation and lattice plane will be described. An individual orientation is indicated by [ ], a collective orientation is by < >, an individual plane is by ( ), and a collective plane is by { }. For a negative exponent, " - " (bar) is supposed to be positioned over a number in the crystallography, but in this description, a negative sign is positioned before a number.

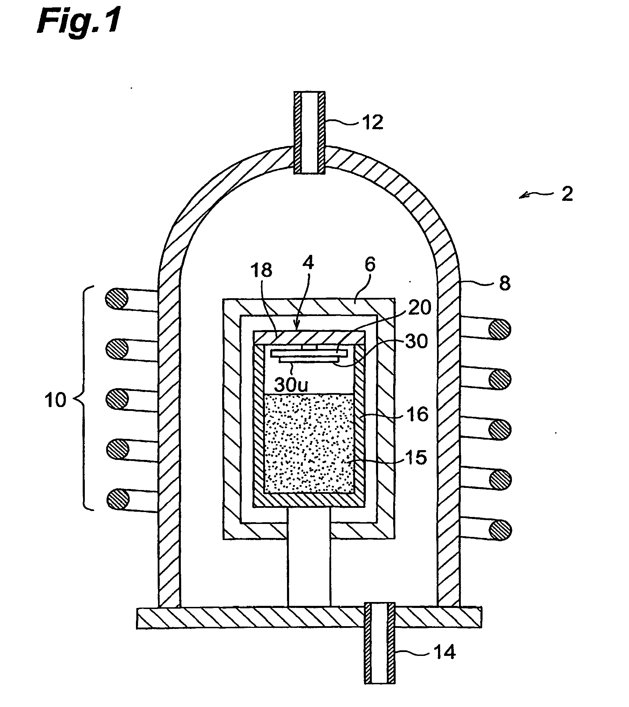

Fig. 1 is a cross-sectional view depicting a crystal growth system 2 for growing the SiC single crystal of the present invention. The crystal growth system 2 comprises a crucible 4 made of graphite where the SiC single crystal is grown inside, a heat shield element 6 for preventing the heat of the crucible 4 from being discharged to the outside, a water-cooled reaction tube 8 surrounding the heat shield element 6, and a high frequency coil 10 which winds around the reaction tube 8 and is used for heating the crucible 4. At the top of the reaction tube 8, a gas supply tube 12 is inserted for supplying such inactive gas as argon gas, and at the base of the reaction tube 8, a gas exhaust tube 14 is inserted for exhausting the inactive gas to the outside.

The crucible 4 is comprised of a container part 16, which has a cylindrical shape with a base and contains material 15 comprised of an SiC poly-crystal, a cover part 18, which seals the top opening of the container part 16, and a seed crystal placement part 20, which is installed at the cover part 18 and where the seed crystal 30 is secured on the bottom face.

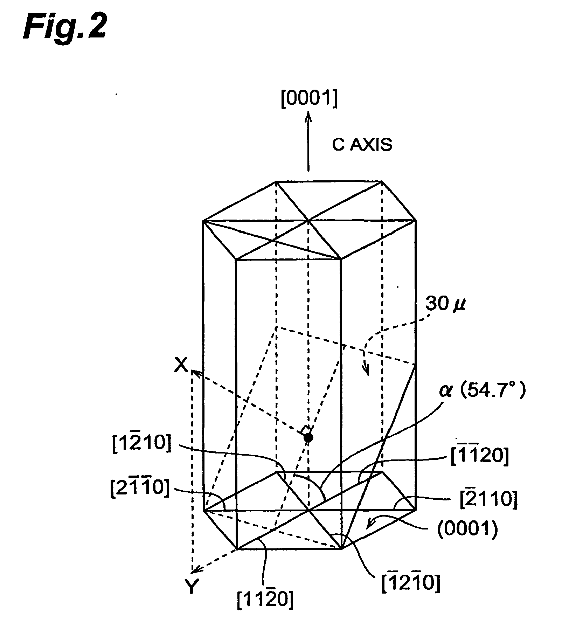

Now the seed crystal 30 of the present embodiment will be described with reference to Fig. 2. As Fig. 2 shows, for the seed crystal 30, a 4H poly type ("H" refers to a hexagonal system and "4" refers to a crystal structure where one cycle is four stacks of atomic layers) SiC single crystal where a plane 30u (1) shifted with respect to the {0001} plane through an angle α (α = 54.7°), (2) where the vector Y when the normal vector X thereof is projected on the {0001} plane and [11-20] orientation, which is one of <11-20>, are within 15° but not parallel, is exposed, is used.

Now a method of growing an SiC single crystal will be described with reference to Fig. 1 - Fig. 4.

After placing a crucible 4 containing the material 15 and the seed crystal 30 in the reaction tube 8, the inside of the reaction tube 8 is evacuated for about one hour, then inactive gas is supplied from the gas supply tube 12 to set the pressure inside the reaction tube 8 to be the normal pressure (about 1.013 x 10⁵ Pa). After evacuating the inside of the reaction tube 8 for about 10 minutes, inactive gas is supplied from the gas supply tube 12 to set the pressure inside the reaction tube 8 again to be the normal pressure (about 1.013 x 10⁵ Pa).

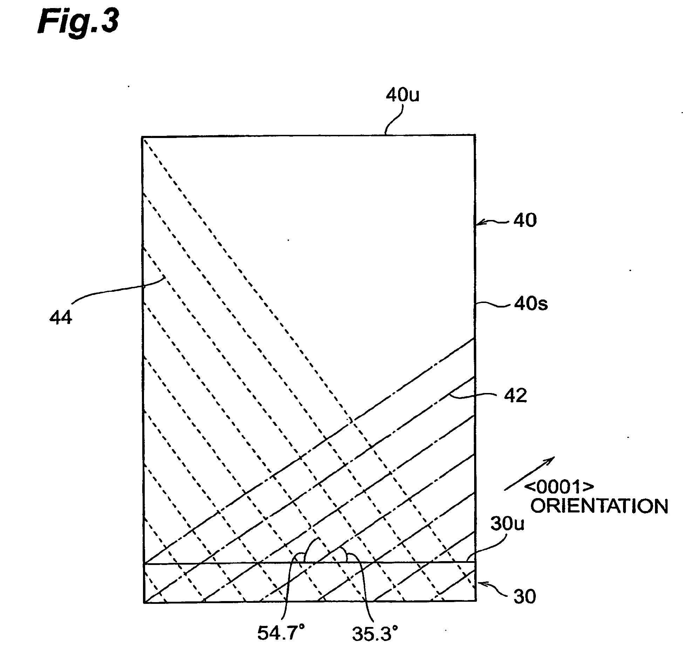

After the above operation ends, the crucible 4 is heated by the high frequency coil 10. At this time, the temperature of the crucible 4 is set to about 2000°C, and a temperature gradient is created so that the temperature of the seed crystal 30 is about 50°C lower than the temperature of the material 15. At the same time, the pressure inside the reaction tube 8 is deceased to about 5.3 x 10² Pa. By this, the material 15 comprised of SiC poly-crystals is sublimated, the gas of the material 15 reaches the seed crystal 30, and the 4H poly type SiC single crystal 40 with about a 2 inch diameter can be grown on the surface (exposed plane) 30u of the seed crystal 30, as shown in Fig. 3. In Fig. 3, the SiC single crystal 40 is positioned above the seed crystal 30 to make the invention easier to understand, but actually the SiC single crystal 40 grows below the seed crystal 30, as'shown in Fig. 1.

Now the growth process of the SiC single crystal 40 will be described with reference to Fig. 3. Normally when an SiC single crystal is grown, a micro-pipe which extends in the <0001> orientation and a stacking fault which spreads on a plane perpendicular to the <0001> orientation tend to be included inside the SiC single crystal. And if a device is fabricated using an SiC single crystal where many micro-pipes and stacking faults are exposed on the surface, leak current may be generated.

So if a seed crystal 30 where a plane (1) shifted with respect to the {0001} plane through an angle α (α = 54.7°) (2) where the vector Y when the normal vector X thereof is projected onto the {0001} plane and [11-20] orientation, which is one of <11-20>, are within 15° but not parallel, is exposed, is used as shown in the present embodiment, the surface 30u of the seed crystal 30 has about a 35.3° inclination with respect to a <0001> orientation where the micro-pipe 42 (shown by the dashed line in Fig. 3) extends. Therefore if the SiC single crystal 40 is grown to a certain extent, the micro-pipe 42 reaches the side face 40s of the SiC single crystal 40, and the state for the micro-pipe 42 to reach the surface 40u can be suppressed. The surface 30u of the seed crystal 30 has about a 54.7° inclination with respect to the plane where the stacking fault 44 (shown by the broken line in Fig. 3) spread, that is, a plane perpendicular to the <0001> orientation. Therefore if the SiC single crystal 40 is grown to a certain extent, the stacking fault 44 reaches the side face 40s of the SiC single crystal 40, and the state for the stacking fault to reach the surface 40u can be suppressed.

As stated in the paper by Sugiyama et al in Proceedings, Vol. 423, p. 583, 1996 of the Symposium of Material Research Society, when a crystal is grown using a seed crystal where the (0001) plane is on the surface, the growth speed is faster in the <11-20> orientation than in the <1-100> orientation, and the obtained crystal has the tendency to be a hexagonal prism where the <11-20> orientation is an edge. This phenomenon is generated by the difference between the bonding hands of the Si atoms and the C atoms, which appear on the surface. And by making the vector Y to be within 15° with the [11-20] orientation since the bonding hands between Si atoms and C atoms are different, the speed for the micro-pipe 42 and the stacking fault 44 to reach the side face 40s of the SiC single crystal 40 increases, and the micro-pipe 42 and the stacking fault 44 to be exposed on the surface 40u of the SiC single crystal 40 decreases, as shown in a later mentioned embodiment.

The angle α is not limited to 54.7°, but is 20° < α < 60°. As the later mentioned example shows, the micro-pipe 42 does not reach the side face 40s of the SiC single crystal 40 if the angle α is 20° or less, and the stacking fault 44 does not reach the side face 40s if the angle α is 60° or more. As stated in Physical Status Solids (b), Vol. 202, p. 5, 1997, a micro-pipe does not always extend in the <0001> orientation, but may extend with some inclination, so the angle α is preferably 25° and more to 55° or less. If the angle α is in this range, the possibility for the micro-pipe 42 and the stacking fault 44 to reach the side face 40s of the SiC single crystal 40 can be increased.

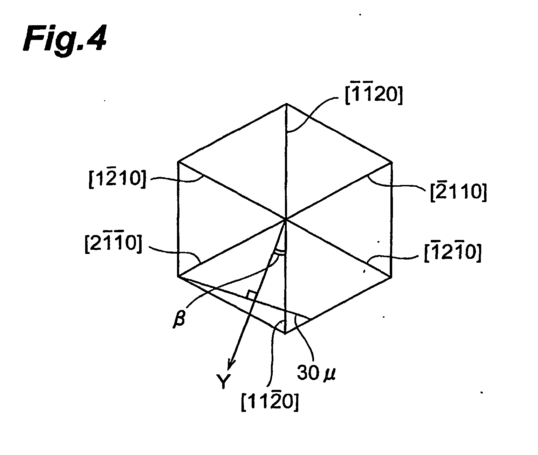

As Fig. 4 shows, according to the invention, the vector Y and [11-20] orientation are not in parallel, but form angle β thereof to be within 15°. If the angle β is within 15°, the speed when the micro-pipe 42 and the stacking fault 44 reaches the side face 40s of the SiC single crystal 40 increases, and the state where these defects reach the surface of the SiC single crystal 40 can be effectively prevented. Also, as the later mentioned example shows, if the angle β is within 10°, the defect density can be further decreased. In the present embodiment, the angle β is the angle between the vector Y and the individual orientation [11-20], but the angle β may be the angle between the vector Y and another individual orientation included in the collective orientation <11-20>.

In the above embodiment, the case when a SiC single crystal is grown by a sublimation method was described, but an SiC single crystal may be grown on the seed crystal in a reactor by a chemical vapor deposition method.

### [Examples]

### Example 1 (not in accordance with the invention)

In Example 1, a 4H-SiC single crystal with angles α = 24° and β = 0° was used for the seed crystal 30. Inactive gas was supplied to the reaction tube 8, pressures was maintained at about 1.013 x 10⁵ Pa, the temperature of the material 15 was set to about 2300°C, and the temperature of the seed crystal 30 was set at about 2170°C. By setting the temperature under normal pressure in this way, growth of a crystal with poor crystalline properties can be prevented. After this, the pressure inside the reaction tube 8 was decreased to 5.3 x 10² Pa, and an SiC single crystal 40 with a 2 inch diameter was bulk-grown on the seed crystal 30. Growth speed at this time was about 0.7 mm/h, and the thickness of the SiC single crystal 40 was 56mm.

The SiC single crystal 40 grown in this way was analyzed by Raman spectroscopic analysis, and it was discovered that the entire surface is the 4H type. Then the bulk of the SiC single crystal 40 was sliced into wafers at about a 330µm thickness, and was polished by a diamond grinding wheel in order to make the front and rear faces of the wafer to be mirror faces. By visual inspection, the wafers of the SiC single crystal were homogeneous on the entire surfaces, and poly-crystallization from the edges and polymorphism of crystals did not occur. Wafers were then etched using fused potassium hydroxide and were evaluated, and as a result, no micro-pipes and stacking faults were observed on the surfaces of the wafers.

### Example 2

In Example 2, a 6H-SiC single crystal with angles α = 30° and β = 5° was used for the seed crystal 30. Pressure inside the reaction tube 8 was maintained at about 3.99 x 10³ Pa, the temperature of the material 15 was set at about 2400°C, the temperature of the seed crystal 30 was set at about 2350°C, and an SiC single crystal 40 with a 2 inch diameter was bulk-grown on the seed crystal 30. The growth speed at this time was 0.7 mm/h, and the thickness of the SiC single crystal 40 was 56mm. And just like Example 1, the bulk of the SiC single crystal 40 was sliced to fabricate wafers, the wafers were etched and evaluated, and as a result, no micro-pipes and stacking faults were observed.

We then checked the defect density of the SiC single crystal changing angle α 5° each time while keeping angle β constant (0°), and obtained the result shown in Table 1. These experiments are not in accordance with the invention. For the evaluation of defect density, all hole, stripe and wedge shaped defects which appeared after 10 minutes of etching with fused potassium hydroxide at 500°C were checked. 4H-SiC was used for the seed crystal.

**Table 1**

| Experiment No. | Angle α (°) | Defect density (cm⁻²) |
|---|---|---|
| 1 | 0 | 113 |
| 2 | 5 | 82 |
| 3 | 10 | 27 |
| 4 | 15 | 20 |
| 5 | 20 | 10 |
| 6 | 25 | 1 |
| 7 | 30 | 0 |
| 8 | 35 | 3 |
| 9 | 40 | 1 |
| 10 | 45 | 0 |
| 11 | 50 | 4 |
| 12 | 55 | 5 |
| 13 | 60 | 10 |
| 14 | 65 | 20 |
| 15 | 70 | 37 |

Angle β = 0°

As Table 1 shows, defect density can be decreased considerably when angle α is at 25° (Experiment 6) or more, that is, higher than 20°, and 55° (Experiment 12) or less, that is, less than 60°.

We then checked the defect density of the SiC single crystal changing angle β 5° each time while keeping angle α constant (30°), and obtained the result shown in Table 2. 4H-SiC was used for the seed crystal. Experiment 1 is not in accordance with the invention (β=0°).

**Table 2**

| Experiment No. | Angle β (°) | Defect density (cm⁻²) |
|---|---|---|
| 1 | 0 | 0 |
| 2 | 5 | 0 |
| 3 | 10 | 5 |
| 4 | 15 | 10 |
| 5 | 20 | 25 |

| | | |
|---|---|---|
| Angle α = 30° | | |

As Table 2 shows, defect density can be decreased considerably when angle β is within 15° (Experiment 4), and can be decreased even more when angle β is within 10° (Experiment 3).

### Example 3 (not in accordance with the invention)

In Example 3, a SiC wafer obtained by Example 1 was used as a seed crystal, and an SiC single crystal was grown on the seed crystal by a Chemical Vapor Deposition method (CVD method). This seed crystal was angle α = 24° and angle β = 0°, just like the seed crystal in Example 1.

At first, vapor phase etching by HCl/H₂ gas was performed on the SiC wafer at 1300°C, then the temperature was increased to 1500°C, and material gas (e.g. silane: SiH₄, propane: C₃H₈) was supplied to start growth. In the chemical vapor deposition method, an n-type SiC buffer layer with effective donor density 3 x 10¹⁷ cm⁻³ - 4 x 10¹⁷ cm⁻³) was grown for 4.6µm, then an n-type active layer with effective donor density 1 x 10¹⁶ cm⁻³ - 2 x 10¹⁶ cm⁻³ was grown for 12µm. During growth, n-type conductivity was controlled by adding nitrogen gas. The major growth conditions at this time are as follows. For the flow rate, all values indicated here are values which have been converted for standard conditions.

| Buffer layer: | |
|---|---|
| SiH₄ flow rate | 0.30 cm³/min |
| C₃H₈ flow rate | 0.20 cm³/min |
| N₂ flow rate | 6 x 10⁻² cm³/min |
| H₂ flow rate | 3.0 1/min |
| Substrate temperature | 1500°C |
| Growth time | 110 min |

| Active layer: | |
|---|---|
| SiH₄ flow rate | 0.50 cm³/min |
| C₃H₈ flow rate | 0.50 cm³/min |
| N₂ flow rate | 2 x 10⁻² cm³/min |
| H₂ flow rate | 3.0 l/min |
| Substrate temperature | 1500°C |
| Growth time | 180 min |

The surface of the SiC single crystal grown under these conditions was observed by a differential interference optical microscope, and it was discovered that the surface is in a mirror status. According to evaluation by KOH etching, it was discovered that micro-pipes and stacking faults did not reach the surface.

### Example 4 (not in accordance with the invention)

In Example 4, the seed crystal, the same as Example 1 (angle α = 24°, angle β = 0°) was placed on the SiC-coated support table, and an SiC single crystal was grown on the seed crystal in a reaction tube by a chemical vapor deposition method (CVD method). After performing vapor phase etching by H₂ gas on the seed crystal at 1800°C, the temperature was increased to 2100°C, and material gas (e.g. silane: SiH₄, propane: C₃H₈) was supplied to start growth. The growth conditions are as follows.

| | |
|---|---|
| SiH₄ flow rate | 50 cm³/min |
| C₃H₈ flow rate | 30 cm³/min |
| H₂ flow rate | 10.0 l/min |
| Substrate temperature | 2100°C |

An SiC single crystal was grown until thickness became 35mm under these conditions. The surface of the grown-SiC single crystal was observed by a differential interference optical microscope, and it was discovered that [the surface] is in a mirror status. According to evaluation by KOH etching, it was discovered that micro-pipes and stacking faults did not reach the surface.

The invention of the present inventor were described specifically based on embodiments, but the present invention is not restricted by the above embodiments. For example, the crystal growth system for growing an SiC single crystal is not limited to the one shown in Fig. 1, but various other types can be used instead.

### INDUSTRIAL APPLICABILITY

In the SiC single crystal of the present invention, micro-pipes and stacking faults are hardly exposed on the surface, and according to the method of growing an SiC single crystal of the present invention, micro-pipes and stacking faults exposed on the surface of the SiC single crystal can be decreased.

## Claims

1. A method of growing an SiC single crystal, in which an SiC single crystal is grown on a seed crystal comprised of an SiC single crystal in which a plane, shifted with respect to a {0001} plane through an angle α (20° < α < 60°) where an angle β, formed between a vector, when the normal vector thereof is projected on the {0001} plane, and an <11-20> orientation, is within 15°, is exposed, provided that β=0° is excluded

2. The method of growing an SiC single crystal according to Claim 1, in which said angle α is 25° or more and 55° or less.

3. The method of growing an SiC single crystal according to Claim 1 or Claim 2, in which said angle β is within 10°.

4. The method of growing an SiC single crystal according to one of Claims 1 to 3, in which said seed crystal is placed in a crucible made of graphite, and said SiC single crystal is recrystallized on said seed crystal by sublimating SiC material powder in said crucible.

5. The method of growing an SiC single crystal according to one of Claims 1 to 3, in which said seed crystal is placed in a reactor, and said SiC single crystal is grown on said seed crystal in said reactor by a chemical vapor deposition method.

6. A bulk SiC single crystal, **characterized by** being obtainable by the method of growing an SiC single crystal according to one of Claims 1 to 5.

## Patentansprüche

1. Verfahren zum Züchten eines SiC-Einkristalls, in dem ein SiC-Einkristall auf einem Impfkristall gezüchtet wird, der einen SiC-Einkristall umfasst, in dem eine Ebene, die in bezug auf eine {0001}-Ebene um einen Winkel α (20° < α < 60°) verschoben ist, wo ein Winkel β, gebildet zwischen einem Vektor, wenn der Normalvektor davon auf die {0001}-Ebene projiziert ist, und einer <11-20>-Orientierung innerhalb von 15° ist, exponiert ist, mit der Massgabe, dass β = 0° ausgeschlossen ist.

2. Verfahren zum Züchten eines SiC-Einkristalls gemäss Anspruch 1, in dem der Winkel α 25° oder mehr und 55° oder weniger ist.

3. Verfahren zum Züchten eines SiC-Einkristalls gemäss Anspruch 1 oder 2, in dem der Winkel β innerhalb von 10° liegt.

4. Verfahren zum Züchten eines SiC-Einkristalls gemäss einem der Ansprüche 1 bis 3, in dem der Impfkristall in einen Tiegel gestellt wird, der aus Graphit hergestellt ist, und der SiC-Einkristall auf dem Impfkristall durch Sublimieren von Pulver aus SiC-Material in dem Tiegel rekristallisiert wird.

5. Verfahren zum Züchten eines SiC-Einkristalls gemäss mindestens einem der Ansprüche 1 bis 3, in dem der Impfkristall in einen Reaktor gestellt wird und der SiC-Einkristall auf dem Impfkristall im Reaktor durch ein chemisches Gasphasenabscheidungsverfahren gezüchtet wird.

6. SiC-Volumeneinkristall, **dadurch gekennzeichnet, dass** er erhältlich ist nach dem Verfahren zum Züchten eines SiC-Einkristalls gemäss mindestens einem der Ansprüche 1 bis 5.

## Revendications

1. Procédé de croissance d'un monocristal de SiC, dans lequel on fait croître un monocristal de SiC sur un cristal germe comprenant un monocristal de SiC dans lequel un plan, décalé par rapport à un plan {0001} d'un angle α (20° < α < 60°) où un angle β, formé entre un vecteur, lorsque son vecteur normal est projeté sur le plan {0001}, et une orientation <11-20>, est inférieur ou égal à 15°, est exposé, à condition que β = 0° soit exclu.

2. Procédé de croissance d'un monocristal de SiC selon la revendication 1, dans lequel ledit angle α est de 25° ou plus et de 55° ou moins.

3. Procédé de croissance d'un monocristal de SiC selon la revendication 1 ou la revendication 2, dans lequel ledit angle β est inférieur ou égal à 10°.

4. Procédé de croissance d'un monocristal de SiC selon l'une des revendications 1 à 3, dans lequel ledit cristal germe est placé dans un creuset réalisé en graphite, et ledit monocristal de SiC est mis à recristalliser sur ledit cristal germe en sublimant de la poudre de matériau de SiC dans ledit creuset.

5. Procédé de croissance d'un monocristal de SiC selon l'une des revendications 1 à 3, dans lequel ledit cristal germe est placé dans un réacteur, et ledit monocristal de SiC est mis à croître sur ledit cristal germe dans ledit réacteur par un procédé de dépôt chimique en phase vapeur.

6. Monocristal de SiC volumineux, **caractérisé par le fait qu'**il peut être obtenu par le procédé de croissance d'un monocristal de SiC selon l'une des revendications 1 à 5.
